# EUROPEAN PATENT APPLICATION

(11) **EP 4 765 615 A1**
(43) Date of publication of application: **24.06.2026**
(21) Application number: 24861513.0
(22) Date of filing: 26.04.2024
(51) Int. Cl.: H02M 7/00, H02M 7/42, H02K 5/02

(54) **PHOTOVOLTAIC INVERTER AND POWER CONVERSION APPARATUS**

(30) Priority: 05.09.2023 CN 202322409746 U
(71) Applicant: Huawei Digital Power Technologies Co., Ltd., Shenzhen, Guangdong 518043 (CN)
(72) Inventor: CHEN, Chao, Shenzhen, Guangdong 518043 (CN); YU, Huiyong, Shenzhen, Guangdong 518043 (CN); WANG, Shiguang, Shenzhen, Guangdong 518043 (CN); GAO, Feng, Shenzhen, Guangdong 518043 (CN); ZHANG, Xiufeng, Shenzhen, Guangdong 518043 (CN); ZHAO, Fugao, Shenzhen, Guangdong 518043 (CN); HAN, Xiaoliang, Shenzhen, Guangdong 518043 (CN)
(74) Representative: Maiwald GmbH
(86) International application number: PCT/CN2024/090143
(87) International publication number: WO 2025/050663

(57) **Abstract**

This application provides a photovoltaic inverter and a power conversion apparatus. The photovoltaic inverter includes: a housing, a circuit board, a rotary switch, a photovoltaic connector, a signal connector, and an alternating current connector. The housing includes a shell and a cover plate. The shell and the cover plate enclose an accommodating chamber. The shell includes a first side plate and a second side plate that are adjacent. The circuit board is disposed in the accommodating chamber. The rotary switch, the photovoltaic connector, the signal connector, and the alternating current connector are all connected to the circuit board through a rigid metal conductor. The photovoltaic connector, the signal connector, and the alternating current connector are installed on the first side plate. The signal connector is located between the photovoltaic connector and the alternating current connector. The rotary switch is installed on the second side plate. The rotary switch, the photovoltaic connector, the signal connector, the alternating current connector, and the like are directly connected to the circuit board, so that occupied space can be reduced and integration of the entire inverter can be improved. In addition, the photovoltaic connector, the signal connector, and the alternating current connector are arranged on one side, which facilitates installation and subsequent maintenance.

## Description

This application claims priority to Chinese Patent Application No. 202322409746.5, filed with the China National Intellectual Property Administration on September 5, 2023 and entitled "PHOTOVOLTAIC INVERTER AND POWER CONVERSION APPARATUS", which is incorporated herein by reference in its entirety.

### TECHNICAL FIELD

Embodiments of this application relate to the field of photovoltaic technologies, and specifically, to a photovoltaic inverter and a power conversion apparatus.

### BACKGROUND

In the industry of photovoltaic inverters, integration and simplification of a power distribution device become a trend. The integration and simplification of the power distribution device help reduce manufacturing costs of the photovoltaic inverter. Currently, power distribution devices such as a photovoltaic connector, a rotary switch, an alternating current connector, and a signal connector are usually connected to a circuit board through a cable. A layout of the power distribution device determines a length of the cable. When there are a plurality of power flows and signal flows, in limited space, the cable has problems of an insufficient bending radius, a risk of incorrect installation, a large quantity of processes, and low efficiency.

### SUMMARY

This application provides a photovoltaic inverter and a power conversion apparatus, to reduce an installation process and improve installation efficiency of a connector.

According to a first aspect, a photovoltaic inverter is provided. The photovoltaic inverter includes: a housing, including a shell and a cover plate, where the shell and the cover plate enclose an accommodating chamber, and the shell includes a first side plate and a second side plate that are adjacent; a circuit board, disposed in the accommodating chamber, where the circuit board further includes a power module, and the power module is fastened to the circuit board through pins; a photovoltaic connector, disposed on the first side plate, where one end of the photovoltaic connector is configured to connect to a photovoltaic module; an alternating current connector, disposed on the first side plate and configured to connect to a load or a power grid; a signal connector, disposed on the first side plate, located between the photovoltaic connector and the alternating current connector, and configured to communicate data with an external device; a rotary switch, disposed on the second side plate, where a part of the rotary switch is located inside the accommodating chamber, a part of the rotary switch is located outside the accommodating chamber, and the rotary switch is electrically connected between the power module and the other end of the photovoltaic connector; and a controller, configured to: when detecting that a fault including short circuit, overcurrent, or overvoltage occurs in the photovoltaic inverter or the photovoltaic module, control the rotary switch to disconnect the photovoltaic module from the power module.

According to the photovoltaic inverter provided in this embodiment of this application, the rotary switch, the photovoltaic connector, the signal connector, the alternating current connector, and the like are directly connected to the circuit board. In this way, occupied space can be reduced, an installation process can be reduced, integration of the entire inverter can be improved, costs can be reduced, and installation efficiency of a connector can be improved. In addition, the photovoltaic connector, the signal connector, and the alternating current connector are arranged on one side to facilitate installation and subsequent operation and maintenance. In addition, when detecting that a fault such as short circuit, overcurrent, or overvoltage occurs in the photovoltaic inverter or the photovoltaic module, the controller in the photovoltaic inverter can control the rotary switch in a timely manner to disconnect the photovoltaic module from the power module, thereby avoiding damage to the photovoltaic inverter.

With reference to the first aspect, in some implementations of the first aspect, the first side plate and the second side plate are connected on a first side edge, and the rotary switch and the photovoltaic connector are both installed close to the first side edge.

According to the photovoltaic inverter provided in this embodiment of this application, the photovoltaic connector and the rotary switch are arranged nearby, and installed and then connected to the board without using a cable, thereby improving space utilization of the entire inverter.

With reference to the first aspect, in some implementations of the first aspect, electrical elements such as a power inverter assembly, a bus capacitor, and an inductor are installed on the circuit board. The electrical elements such as the power inverter assembly, the bus capacitor, and the inductor may be connected to the circuit board through pins.

In some embodiments, the circuit board includes an inverter circuit and a rectifier circuit. The inverter circuit is configured to invert a direct current into an alternating current. The rectifier circuit is configured to rectify an alternating current to a direct current.

In some embodiments, the circuit board further includes a filter circuit and a measuring circuit. A direct current of the photovoltaic module is filtered by the filter circuit and measured by the measuring circuit, and then output as an alternating current through the inverter circuit.

With reference to the first aspect, in some implementations of the first aspect, the photovoltaic inverter further includes an energy storage connector. The energy storage connector is connected to the circuit board. The energy storage connector is installed on the first side plate and is located between the photovoltaic connector and the signal connector. The energy storage connector is further configured to connect to an energy storage device.

According to the photovoltaic inverter provided in this embodiment of this application, the energy storage connector can obtain a direct current from an external energy storage apparatus, and output the direct current to the inverter circuit on the circuit board; and the inverter circuit can invert the direct current into an alternating current for use. In addition, the energy storage connector may further transmit electric energy to the external energy storage apparatus, that is, output a direct current to the external energy storage apparatus. It should be understood that when the external energy storage apparatus (for example, a battery pack) is charged, a source of electric energy may be electric energy provided by the photovoltaic module, or may be mains electricity. An alternating current may be rectified to a direct current through the rectifier circuit on the circuit board. The direct current may be transmitted to the external energy storage apparatus (for example, a battery pack) by using the energy storage connector, to charge the external energy storage apparatus (for example, a battery pack).

With reference to the first aspect, in some implementations of the first aspect, the shell includes a bottom plate that is disposed opposite to the cover plate. The circuit board is located between the cover plate and the bottom plate of the shell. A heat sink is connected to a side that is of the bottom plate of the shell and that is away from the circuit board. The circuit board, the side plates of the shell, and the bottom plate of the shell form an accommodating cavity. The accommodating cavity is configured to accommodate the power inverter assembly, the bus capacitor, and the inductor.

It should be understood that by disposing the electronic elements in the accommodating cavity, the electronic elements can be protected, and cavity space can be effectively utilized, to avoid an excessively large cavity, improve space utilization, and also reduce costs. In addition, the electronic elements are located on one side of the heat sink, which helps enhance heat dissipation effect.

It may be understood that the accommodating cavity that is formed by the circuit board, the side plates of the shell, and the bottom plate of the shell may be referred to as a first accommodating cavity, and an accommodating cavity that is formed by the circuit board, the side plates of the shell, and the cover plate may be referred to as a second accommodating cavity. A height of an electronic component accommodated in the first accommodating cavity is higher than a height of an electronic component accommodated in the second accommodating cavity. For example, the height of the electronic component in the first accommodating cavity is less than or equal to 9 cm, and the height of the electronic component in the second accommodating cavity is less than or equal to 5 mm. To be specific, the first accommodating cavity can accommodate an electronic element with a high height, a large volume, and a high heat dissipation requirement, such as a power inverter assembly, a bus capacitor, or an inductor; and the second accommodating cavity can accommodate an electronic element with a low height, a small volume, and a low heat dissipation requirement, such as a surface mount capacitor, a surface mount resistor, or an indicator light.

With reference to the first aspect, in some implementations of the first aspect, the rotary switch is electrically connected to the circuit board through pins, the photovoltaic connector is electrically connected to the circuit board through a rigid conductor, and the photovoltaic connector is electrically connected to the rotary switch through a metal routing on the circuit board. To be specific, the photovoltaic connector is connected to the rotary switch without using a cable, and is connected through a conductor in the circuit board, so that space can be saved and space utilization can be improved.

With reference to the first aspect, in some implementations of the first aspect, the photovoltaic connector includes a plurality of positive connectors and a plurality of negative connectors. The plurality of positive connectors include a plurality of positive terminals, and the plurality of negative connectors include a plurality of negative terminals. The rotary switch is a multi-pole rotary switch. Each of the positive terminals is connected to one pole of the rotary switch through a metal routing on the circuit board. After negative current combination of the plurality of negative terminals, a connection to one pole of the rotary switch is implemented through a metal routing on the circuit board.

Each pole of the multi-pole rotary switch includes two pins (denoted as a first pin and a second pin). The first pin may be connected to the positive terminal or the negative terminal, and the second pin may be connected to the power module on the circuit board. Specifically, the second pin may be connected to the bus capacitor through a metal routing on the circuit board, and the bus capacitor is connected to the power inverter assembly through a metal routing on the circuit board. In this implementation, a connection means an electrical connection, and may be a direct fixed connection or an indirect fixed connection in terms of a structure. There are a plurality of metal routings on the circuit board. The metal routing may also be referred to as a conducting wire, may be a copper wire, and is configured to connect components on the circuit board.

For example, the photovoltaic connector may include three positive connectors and three negative connectors. The three positive connectors include three positive terminals, and the three negative connectors include three negative terminals. The rotary switch may be a four-pole rotary switch (that is, the rotary switch includes four poles). The three positive terminals are respectively connected to first pins of three poles of the four-pole rotary switch through metal routings on the circuit board. Negative current combination may be performed on direct currents input by the three negative terminals. After one path of direct current is obtained through the combination, a connection to a first pin of one pole of the four-pole rotary switch is implemented through a metal routing on the circuit board.

In this implementation, the photovoltaic connector and the pins of the rotary switch, the pins and the bus capacitor, and the bus capacitor and the power inverter assembly are connected through the metal routings. In this way, cables are reduced or use of cables is avoided, thereby reducing installation difficulty.

With reference to the first aspect, in some implementations of the first aspect, the part that is of the rotary switch and that is located inside the accommodating chamber is fastened to the circuit board through pins. The rotary switch is located in the accommodating cavity. The rotary switch is connected to the power module through a metal routing on the circuit board.

For example, the second pin on the rotary switch is connected to the power module through a metal routing on the circuit board. Specifically, the second pin on the rotary switch may be connected to the bus capacitor through a metal routing on the circuit board, and the bus capacitor is connected to the power inverter assembly through a metal routing on the circuit board.

With reference to the first aspect, in some implementations of the first aspect, the photovoltaic inverter further includes a smart communication stick. The smart communication stick is connected to the circuit board. The smart communication stick is installed on the first side plate and is located between the signal connector and the bottom plate of the shell. In this way, space of the side plate of the housing can be fully used, and a layout is more compact.

It should be understood that the smart communication stick is configured to implement communication with an intelligent management system (cloud), that is, may upload data to the intelligent management system and receive information delivered by the intelligent management system.

In some embodiments, the smart communication stick is connected to the circuit board through a cable. One end of the cable is connected to the circuit board, and the other end of the cable is provided with a USB interface. The USB interface is provided on the shell. The smart communication stick is inserted into the USB interface.

With reference to the first aspect, in some implementations of the first aspect, the photovoltaic inverter further includes an antenna. The antenna is connected to the circuit board. The antenna is installed on the first side plate and is located between the signal connector and the alternating current connector.

It should be understood that the antenna is an external antenna configured with a WLAN, and is used for access maintenance of a proximal application, and may be configured to increase signal strength and expand coverage.

According to a second aspect, a power conversion apparatus is provided. The power conversion apparatus includes: a housing, including a shell and a cover plate, where the shell and the cover plate enclose an accommodating chamber, and the shell includes a first side plate and a second side plate that are adjacent; a circuit board, disposed in the accommodating chamber, where the circuit board further includes a power module, and the power module is fastened to the circuit board through pins; a direct current connector, disposed on the first side plate, where one end of the direct current connector is configured to connect to a photovoltaic module; an alternating current connector, disposed on the first side plate and configured to connect to a load or a power grid; a signal connector, disposed on the first side plate, located between the direct current connector and the alternating current connector, and configured to communicate data with an external device; a rotary switch, disposed on the second side plate, where a part of the rotary switch is located inside the accommodating chamber, a part of the rotary switch is located outside the accommodating chamber, and the rotary switch is electrically connected between the power module and the other end of the direct current connector; and a controller, configured to: when detecting that a fault including short circuit, overcurrent, or overvoltage occurs in the photovoltaic inverter or the photovoltaic module, control the rotary switch to disconnect the photovoltaic module from the power module.

With reference to the second aspect, in some implementations of the second aspect, the first side plate and the second side plate are connected on a first side edge, and the rotary switch and the direct current connector are both installed close to the first side edge.

With reference to the second aspect, in some implementations of the second aspect, electrical elements such as a power inverter assembly, a bus capacitor, and an inductor are installed on the circuit board. The electrical elements such as the power inverter assembly, the bus capacitor, and the inductor may be connected to the circuit board through pins.

With reference to the second aspect, in some implementations of the second aspect, the power conversion apparatus further includes an energy storage connector. The energy storage connector is connected to the circuit board. The energy storage connector is installed on the first side plate and is located between the direct current connector and the signal connector. The energy storage connector is further configured to connect to an energy storage device.

With reference to the second aspect, in some implementations of the second aspect, the shell includes a bottom plate that is disposed opposite to the cover plate. The circuit board is located between the cover plate and the bottom plate of the shell. A heat sink is connected to a side that is of the bottom plate of the shell and that is away from the circuit board. The circuit board, the side plates of the shell, and the bottom plate of the shell form an accommodating cavity. The accommodating cavity is configured to accommodate the power inverter assembly, the bus capacitor, and the inductor.

With reference to the second aspect, in some implementations of the second aspect, the part that is of the rotary switch and that is located inside the accommodating chamber is fastened to the circuit board through pins. The rotary switch is located in the accommodating cavity. The rotary switch is connected to the power module through a metal routing on the circuit board.

With reference to the second aspect, in some implementations of the second aspect, the rotary switch is electrically connected to the circuit board through pins, the direct current connector is electrically connected to the circuit board through a rigid conductor, and the direct current connector is electrically connected to the rotary switch through a metal routing on the circuit board.

With reference to the second aspect, in some implementations of the second aspect, the direct current connector includes a plurality of positive connectors and a plurality of negative connectors. The plurality of positive connectors include a plurality of positive terminals, and the plurality of negative connectors include a plurality of negative terminals. The rotary switch is a multi-pole rotary switch.

Each of the positive terminals is connected to one pole of the rotary switch through a metal routing on the circuit board. After negative current combination of the plurality of negative terminals, a connection to one pole of the rotary switch is implemented through a metal routing on the circuit board.

With reference to the second aspect, in some implementations of the second aspect, the power conversion apparatus further includes a smart communication stick. The smart communication stick is connected to the circuit board. The smart communication stick is installed on the first side plate and is located between the signal connector and the bottom plate of the shell.

With reference to the second aspect, in some implementations of the second aspect, the power conversion apparatus further includes an antenna. The antenna is connected to the circuit board. The antenna is installed on the first side plate and is located between the signal connector and the alternating current connector. The antenna is an external antenna configured with a WLAN, and is used for access maintenance of a proximal application, and may be configured to increase signal strength and expand coverage.

For technical effects of the second aspect, refer to the corresponding descriptions of the first aspect. Details are not described herein again.

### BRIEF DESCRIPTION OF DRAWINGS

FIG. 1 is a diagram of a photovoltaic power generation scenario according to an embodiment of this application;
FIG. 2 is a diagram of a three-dimensional structure of a photovoltaic inverter according to an embodiment of this application;
FIG. 3 is a top view of a photovoltaic inverter according to an embodiment of this application;
FIG. 4 is a diagram of a structure of some components of a photovoltaic inverter according to an embodiment of this application;
FIG. 5 is a side view of a photovoltaic inverter according to an embodiment of this application; and
FIG. 6 is a diagram of a circuit structure of a photovoltaic inverter according to an embodiment of this application.

### DESCRIPTION OF EMBODIMENTS

The following describes technical solutions of this application with reference to accompanying drawings.

In the description of embodiments of this application, unless otherwise stated, "/" means "or", for example, A/B may represent A or B. The term "and/or" in this specification describes only an association relationship between associated objects, and indicates that three relationships may exist. For example, A and/or B may represent three cases: Only A exists, both A and B exist, and only B exists.

The prefix words "first", "second", and the like in embodiments of this application are merely intended to distinguish between different objects, and impose no limitation on locations, sequences, priorities, quantities, content, or the like of the described objects. Use of the prefix words such as ordinal numbers used to distinguish between the described objects in embodiments of this application does not constitute a limitation on the described objects. For descriptions of the described objects, refer to the context descriptions in the claims or embodiments. Use of the prefix words should not constitute a redundant limitation. In addition, in the descriptions of embodiments, unless otherwise specified, "a plurality of" means two or more.

In embodiments of this application, an orientation or a position relationship indicated by the terms "upper", "lower", "left", "right", "front", "rear", "top", "bottom", "inside", "outside", or the like is an orientation or position relationship shown in the accompanying drawings, and is merely intended to facilitate description and simplify description of this application, but is not intended to indicate or imply that a specified apparatus or element needs to have a specific orientation, be constructed in a specific orientation, and operate in a specific orientation. Therefore, this application cannot be construed as a limitation.

Reference to "in some embodiments" or the like described in this specification means that one or more embodiments of this application include a particular feature, structure, or characteristic described with reference to embodiments. Therefore, statements such as "in some embodiments" that appear at different places in this specification do not necessarily mean referring to a same embodiment, instead, they mean "one or more but not all of embodiments", unless otherwise specifically emphasized in another manner. The terms "include", "comprise", "have", and their variants all mean "include but are not limited to", unless otherwise specifically emphasized in another manner.

In this application, "perpendicular" is not strictly perpendicular, but within an allowable error range. "Parallel" is not strictly parallel, but within an allowable error range.

A same reference numeral in embodiments of this application represents a same component or a same part. For a plurality of same parts in embodiments of this application, only one part may be used as an example to mark a reference numeral in the accompanying drawings. For another same part, the reference numeral is also applicable. In addition, dimensions and sizes of the parts shown in the accompanying drawings are merely examples.

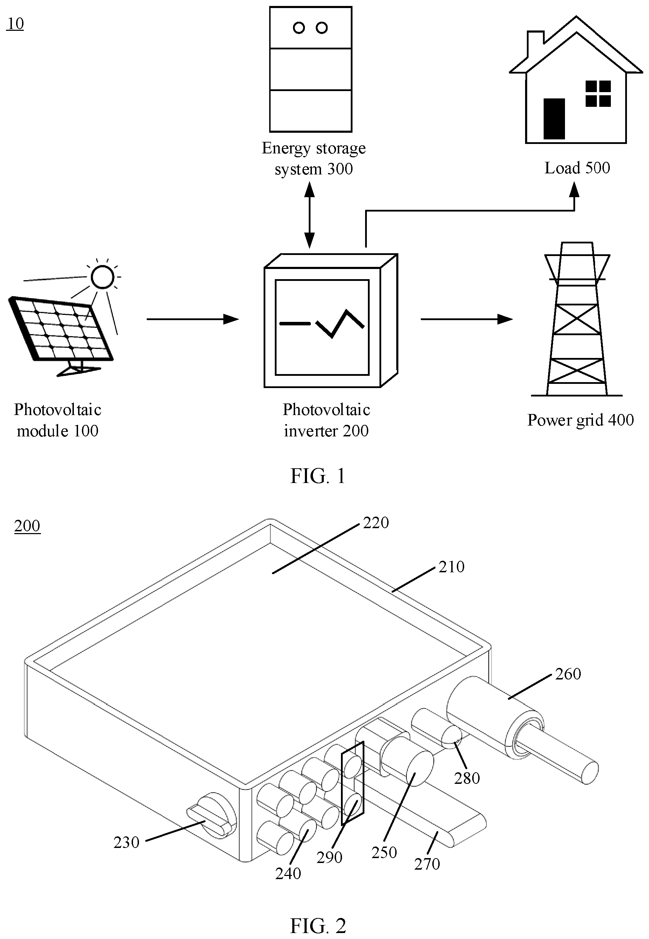

With reference to FIG. 1, the following first describes in detail a photovoltaic power generation scenario provided in an embodiment of this application.

FIG. 1 is a diagram of a photovoltaic power generation scenario according to an embodiment of this application. As shown in FIG. 1, an apparatus in a photovoltaic power generation system 10 includes a photovoltaic module 100, a photovoltaic inverter 200, and an energy storage system 300. Optionally, the photovoltaic power generation system 10 may further include a power grid 400 and a load 500.

Specifically, the photovoltaic inverter 200 can convert a direct current from the photovoltaic module 100 into an alternating current, and transfer the alternating current to the power grid 400 or the load 500. The direct current is also referred to as a direct current, or a DC for short. The alternating current is also referred to as an alternating current, or an AC for short. The photovoltaic inverter 200 may also be referred to as a DC-AC converter. The photovoltaic inverter 200 can transfer the direct current from the photovoltaic module 100 to the energy storage system 300, to charge the energy storage system 300. The photovoltaic inverter 200 can convert a direct current from the energy storage system 300 into an alternating current, and transfer the alternating current to the power grid 400 or the load 500.

The photovoltaic module 100 may also be referred to as a photovoltaic array, and includes a plurality of photovoltaic strings. Photovoltaic is also referred to as photovoltaic, or PV for short. The string is also referred to as a string. Each photovoltaic string includes a plurality of photovoltaic panels that are connected in series. The photovoltaic panel is configured to convert light energy into electric energy. The electric energy generated by the photovoltaic panel is a direct current. A voltage at two ends of the photovoltaic string is equal to a sum of voltages generated by the plurality of photovoltaic panels. An output power of the photovoltaic module 100 may represent electric energy output by the photovoltaic module in a unit time.

An area of each photovoltaic module 100 is usually fixed. When light intensity of light remains unchanged, a larger included angle between light irradiated onto the photovoltaic module 100 and a plane on which the photovoltaic module 100 is located, that is, a smaller incident angle of the light irradiated onto the photovoltaic module 100, indicates more electric energy output by the photovoltaic module 100. When light is perpendicularly irradiated onto the photovoltaic module 100, in other words, when the included angle between the light and the plane on which the photovoltaic module 100 is located is 90°, the included angle reaches a maximum value, and the output power of the photovoltaic module 100 reaches a maximum value.

It may be understood that when the photovoltaic power generation system 10 includes the photovoltaic module 100, the photovoltaic inverter 200, and the energy storage system 300, the photovoltaic inverter 200 is mainly configured to connect the photovoltaic module 100 to the energy storage system 300, to charge the energy storage system 300. When the photovoltaic power generation system 10 includes the photovoltaic module 100, the photovoltaic inverter 200, the energy storage system 300, the power grid 400, and the load 500, the photovoltaic inverter 200 can be configured to connect the foregoing apparatuses. For example, the photovoltaic inverter 200 connects the photovoltaic module 100 to the energy storage system 300; the photovoltaic inverter 200 connects the photovoltaic module 100 to the power grid 400; the photovoltaic inverter 200 connects the photovoltaic module 100 to the load 500; the photovoltaic inverter 200 connects the load 500 to the energy storage system 300; and the like.

The energy storage system 300 in the photovoltaic power generation system 10 can store and release electric energy. For example, the energy storage system 300 may store direct current electric energy from the photovoltaic module 100, and the energy storage system 300 may supply power to the power grid 400 or the load 500 through the photovoltaic inverter 200. Therefore, there are a wide variety of application scenarios of the energy storage system 300. The application scenarios include but are not limited to a household scenario, an industry green power scenario, a smart photovoltaic power station scenario, and the like.

It may be learned from the foregoing descriptions that the photovoltaic inverter 200 is a converter that can convert a direct current into an alternating current. Specifically, the photovoltaic inverter 200 may include two direct current ports (for example, a direct current port 1 and a direct current port 2) and one alternating current port. The two direct current ports are configured to respectively connect to the photovoltaic module 100 and the energy storage system 300. For example, the direct current port 1 is configured to connect to the photovoltaic module 100, and the direct current port 2 is configured to connect to the energy storage system 300. The alternating current port may be configured to output an alternating current. Electricity of the output alternating current may be allocated by using a power distribution box, for example, allocated to the power grid 400 and the load 500.

The photovoltaic module 100 may feed the power grid 400 and supply power to the load 500 through the direct current port. The energy storage system 300 may supply power to the load 500 through the direct current port. The power grid 400 may supply power to the load 500 through the alternating current port. In other words, the photovoltaic inverter 300 is a connection hub between the load 500 and an energy module (which may include the photovoltaic module 100, the energy storage system 300, and the power grid 400).

The following describes in detail a structure of the photovoltaic inverter 200 provided in embodiments of this application with reference to FIG. 2 to FIG. 5.

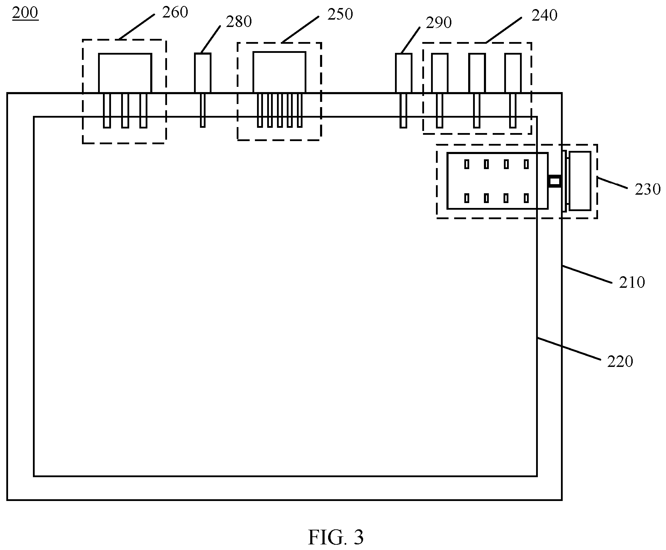

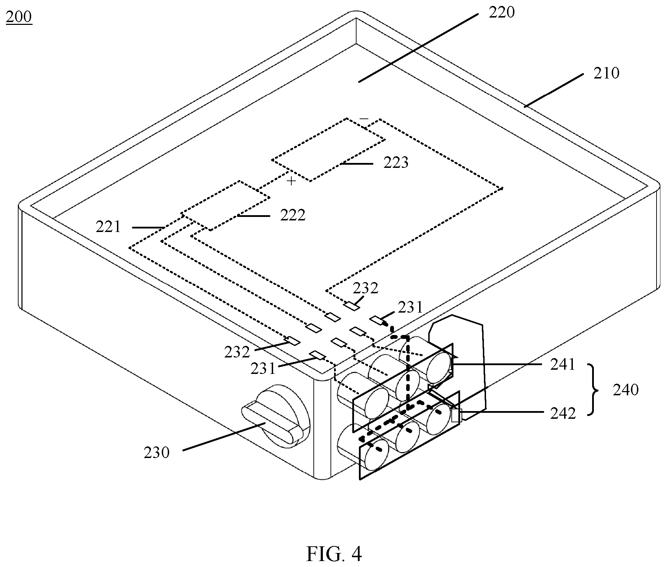

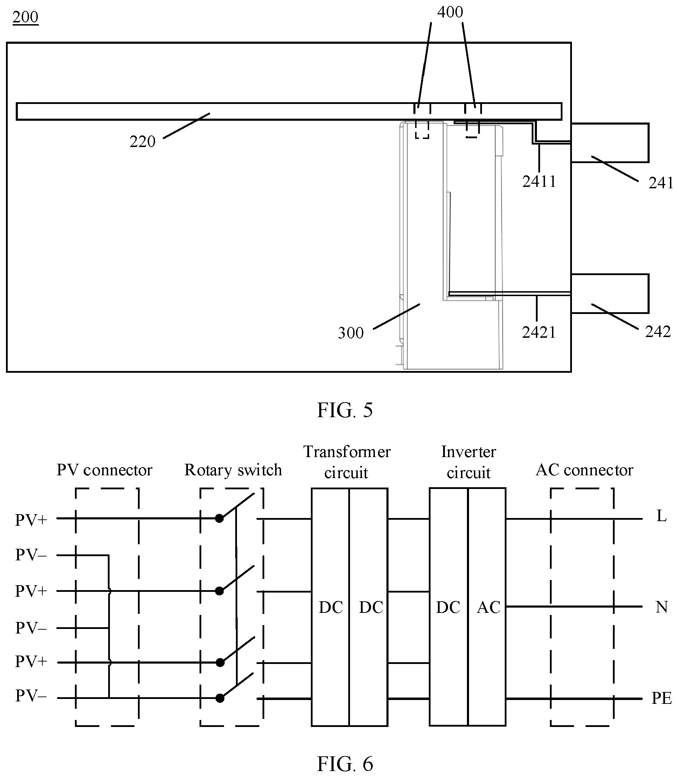

FIG. 2 is a diagram of a three-dimensional structure of a photovoltaic inverter 200 according to an embodiment of this application. FIG. 3 is a top view of a photovoltaic inverter 200 according to an embodiment of this application. FIG. 4 is a diagram of a structure of some components of a photovoltaic inverter 200 according to an embodiment of this application. FIG. 5 is a side view of a photovoltaic inverter 200 according to an embodiment of this application.

As shown in FIG. 2 and FIG. 3, the photovoltaic inverter 200 includes a housing, a circuit board 220, and a power distribution device. The housing can protect the circuit board 220 and the power distribution device. The circuit board 220 obtains a direct current from the photovoltaic module 100 by using the power distribution device, and invert the direct current into an alternating current for output. A signal in a signal flow is interacted between the circuit board 220 and a signal transceiver.

In some embodiments, as shown in FIG. 3, the photovoltaic inverter 200 includes a rotary switch 230, a PV connector 240, a signal connector 250, and an AC connector 260. In other words, the power distribution device includes the rotary switch 230, the PV connector 240, the signal connector 250, and the AC connector 260.

The PV connector 240 is configured to connect to the photovoltaic module 100. A power module is disposed on the circuit board 220. The rotary switch 230 is configured to control connection or disconnection between the photovoltaic module 100 and the power module on the circuit board 220. The signal connector 250 is configured to communicate a signal with an external device (for example, an energy storage apparatus, an electricity meter, or another photovoltaic inverter). The alternating current connector 260 is configured to connect to the load 500 or the power grid 400. A direct current input by the photovoltaic module 100 flows through the photovoltaic connector 240 and the rotary switch 230, and then is transmitted to the power module on the circuit board 220. The power module may convert the direct current into an alternating current, and transmit the alternating current to the power grid 400 or the load 500.

The rotary switch 230 may be directly connected to the circuit board 220 through pins. The PV connector 240 and the circuit board 220 may be connected through a rigid conductor. The PV connector 240 is connected to the rotary switch 230 without using a cable, and implements an electrical connection through a metal routing on the circuit board 220. The signal connector 250 is directly inserted into the circuit board 220 without using a cable for connection. The AC connector 260 is directly coupled to the circuit board 220 through a conductor connected to the circuit board.

It should be understood that the rotary switch 230 is electrically connected to the circuit board 220 through the pins, the photovoltaic connector 240 is electrically connected to the circuit board 220 through the rigid conductor, and the photovoltaic connector 240 is electrically connected to the rotary switch 230 through the metal routing on the circuit board 220. In other words, the PV connector 240 is connected to the rotary switch 230 without using a cable, so that space can be saved and space utilization can be improved.

The photovoltaic inverter 200 includes the housing, the circuit board 220, the rotary switch 230, the photovoltaic connector 240, the signal connector 250, the alternating current connector 260, and a controller. The housing includes a shell 210 and a cover plate. The shell 210 and the cover plate enclose an accommodating chamber. The shell 210 includes a first side plate and a second side plate that are adjacent. The circuit board 220 is disposed in the accommodating chamber. The circuit board 220 further includes a power module. The power module is fastened to the circuit board 220 through pins. The photovoltaic connector 240 is disposed on the first side plate. One end of the photovoltaic connector 240 is configured to connect to the photovoltaic module 100. The alternating current connector 260 is disposed on the first side plate and is configured to connect to the load 500 or the power grid 400. The signal connector 250 is disposed on the first side plate, is located between the photovoltaic connector 240 and the alternating current connector 260, and is configured to communicate data with an external device. The rotary switch 230 is disposed on the second side plate. A part of the rotary switch 230 is located inside the accommodating chamber, and a part of the rotary switch 230 is located outside the accommodating chamber. The rotary switch 230 is electrically connected between the power module and the other end of the photovoltaic connector 240. The controller is configured to: when detecting that a fault including short circuit, overcurrent, or overvoltage occurs in the photovoltaic inverter 200 or the photovoltaic module 100, control the rotary switch 230 to disconnect the photovoltaic module 100 from the power module.

It should be understood that when the controller detects that a fault such as short circuit, overcurrent, or overvoltage occurs in a power device or the photovoltaic module 100 in the photovoltaic inverter 200, the controller may control the rotary switch 230 to disconnect the photovoltaic module 100 from the power module.

In this application, the rotary switch 230, the photovoltaic connector 240, the signal connector 250, the alternating current connector 260, and the like are directly connected to the circuit board 220. In this way, occupied space can be reduced, an installation process can be reduced, integration of the entire inverter can be improved, costs can be reduced, and installation efficiency of a connector can be improved. In addition, the photovoltaic connector 240, the signal connector 250, and the alternating current connector 260 are arranged on one side to facilitate installation and subsequent operation and maintenance. In addition, when detecting that a fault such as short circuit, overcurrent, or overvoltage occurs in the photovoltaic inverter 200 or the photovoltaic module 100, the controller in the photovoltaic inverter 200 can control the rotary switch 230 in a timely manner to disconnect the photovoltaic module 100 from the power module, thereby avoiding damage to the photovoltaic inverter 200.

In some embodiments, an edge that is of the first side plate and that is connected to the second side plate may be denoted as a first side edge. The rotary switch 230 and the PV connector 240 are both installed close to the first side edge. The photovoltaic connector 240 and the rotary switch 230 are arranged nearby, and connected to the board without using a cable, thereby improving space utilization of the entire inverter.

In some embodiments, as shown in FIG. 4 and FIG. 5, the photovoltaic connector 240 includes a plurality of positive connectors 241 and a plurality of negative connectors 242. The plurality of positive connectors 241 include a plurality of positive terminals 2411, and the plurality of negative connectors 242 include a plurality of negative terminals 2421. The rotary switch 230 is a multi-pole rotary switch. Each of the positive terminals 2411 is connected to one pole of the rotary switch 230 through a metal routing 221 on the circuit board 220. After negative current combination of the plurality of negative terminals 2421, a connection to one pole of the rotary switch 230 is implemented through a metal routing 221 on the circuit board 220. It should be understood that the plurality of poles of the rotary switch 230 may be connected or disconnected by turning the rotary switch 230. In other words, the rotary switch 230 may be configured to control connection or disconnection between the photovoltaic module 100 and the power module on the circuit board 220.

Each pole of the multi-pole rotary switch 230 includes two pins (denoted as a first pin 231 and a second pin 232). The first pin 231 may be connected to the positive terminal 2411 or the negative terminal 2421, and the second pin 232 may be connected to the power module on the circuit board 220. Specifically, the second pin 232 may be connected to a bus capacitor 222 through a metal routing 221, and the bus capacitor 222 is connected to a power inverter assembly 223 through a metal routing 221. In this implementation, a connection means an electrical connection, and may be a direct fixed connection or an indirect fixed connection in terms of a structure. There are a plurality of metal routings 221 on the circuit board 220. The metal routing 221 may also be referred to as a conducting wire, may be a copper wire, and is configured to connect components on the circuit board 220.

For example, the photovoltaic connector 240 may include three positive connectors 241 and three negative connectors 242. The three positive connectors 241 include three positive terminals 2411, and the three negative connectors 242 include three negative terminals 2421. One connector includes one terminal. The rotary switch 230 may be a four-pole rotary switch (that is, the rotary switch 230 includes four poles). The three positive terminals 2411 are respectively connected to first pins 231 of three poles of the four-pole rotary switch 230 through the metal routings 221. Negative current combination may be performed on direct currents input by the three negative terminals 2421. After one path of direct current is obtained through the combination, a connection to a first pin 231 of one pole of the four-pole rotary switch 230 is implemented through a metal routing 221 on the circuit board 220.

In this implementation, the photovoltaic connector 240 and the pins of the rotary switch 230, the pins and the bus capacitor 222, and the bus capacitor 222 and the power inverter assembly 223 are connected through the metal routings 221. In this way, cables are reduced or use of cables is avoided, thereby reducing installation difficulty.

It should be noted that a position of 221 shown in FIG. 4 is used only to indicate that the circuit board 220 has a metal routing 221, and does not represent an actual position of the metal routing 221. It should be understood that, in this application, the metal routing 221 on the circuit board 220 may be routed based on a functional component in the photovoltaic inverter 200, to implement functions of the photovoltaic inverter 200.

As shown in FIG. 5, the circuit board 220 and a support 300 that is connected to the circuit board are located in the housing. The positive connector 241 and the negative connector 242 are electrically connected to the circuit board 220 through the support 300 that is connected to the circuit board. The support 300 that is connected to the circuit board may be connected to the circuit board 220 through a screw 400. The photovoltaic connector 240 (including the positive connector 241 and the negative connector 242) may be electrically connected to the circuit board 220 through the support 300 that is connected to the circuit boardwithout using a cable. In this way, the installation process can be reduced and connection reliability can be improved.

The part that is of the rotary switch 230 and that is located inside the accommodating chamber is fastened to the circuit board 220 through pins. The rotary switch 230 is located in the accommodating cavity (that is, the first accommodating cavity described below). The rotary switch 230 is connected to the power module through a metal routing 221 on the circuit board 220.

For example, the second pin 232 on the rotary switch 230 is connected to the power module through the metal routing 221 on the circuit board 220. Specifically, the second pin 232 on the rotary switch 220 may be connected to the bus capacitor 222 through a metal routing 221 on the circuit board 220. The bus capacitor 222 may be connected to the power inverter assembly 223 through a metal routing 221 on the circuit board 220.

In some embodiments, the circuit board 220 includes an inverter circuit. The inverter circuit is configured to: perform inversion processing on the direct current of the photovoltaic module 100, and then output an alternating current.

In some embodiments, the circuit board 220 further includes a rectifier circuit. The rectifier circuit is configured to rectify an alternating current to a direct current.

In some embodiments, the circuit board 220 further includes a filter circuit and a measuring circuit. A direct current of the photovoltaic module 100 is filtered by the filter circuit and measured by the measuring circuit, and then output as an alternating current through the inverter circuit.

The circuit board 220 may be a printed circuit board. The printed circuit board is a support body of an electronic element, and also serves as a carrier for an electrical connection of the electronic element. The printed circuit board has a function of supporting circuit elements and interconnecting the circuit elements. The electronic element includes but is not limited to a capacitor, an inductor, a resistor, a processor, a memory, an antenna, and the like. Usually, a printed circuit board on which no electronic element is soldered may be referred to as a single PCB board. A printed circuit board on which an electronic element is soldered may be referred to as a printed circuit board assembly (printed circuit board assembly, PCBA).

Electronic elements carried on the printed circuit board may form a plurality of functional modules to implement corresponding functions. For example, the inverter circuit is configured to convert a direct current into an alternating current, and the rectifier circuit is configured to convert an alternating current into a direct current. A shape of the printed circuit board may be correspondingly designed based on a shape of an electronic device, and positions, shapes, and the like of functional modules to be disposed in the electronic device.

In some embodiments, electrical elements such as the power inverter assembly 223, the bus capacitor 222, and the inductor are installed on the circuit board 220. The electrical elements such as the power inverter assembly 223, the bus capacitor 222, and the inductor may be connected to the circuit board 220 through pins.

In some embodiments, the shell 210 includes a bottom plate that is disposed opposite to the cover plate. The circuit board 220 is located between the cover plate and the bottom plate of the shell 210. A heat sink is connected to a side that is of the bottom plate of the shell 210 and that is away from the circuit board 220. The circuit board 220, the side plates of the shell 210, and the bottom plate of the shell 210 form an accommodating cavity. The accommodating cavity is configured to accommodate electronic elements such as the power inverter assembly 223, the bus capacitor 222, and the inductor. The accommodating cavity may be further configured to accommodate the support 300 that is connected to the circuit board and the rotary switch 230.

It should be understood that by disposing the electronic elements in the accommodating cavity, the electronic elements can be protected, and cavity space can be effectively utilized, to avoid an excessively large cavity, improve space utilization, and also reduce costs. In addition, the electronic elements are located on one side of the heat sink, which helps enhance heat dissipation effect.

It may be understood that the accommodating cavity that is formed by the circuit board 220, the side plates of the shell 210, and the bottom plate of the shell 210 may be referred to as a first accommodating cavity, and an accommodating cavity that is formed by the circuit board 220, the side plates of the shell 210, and the cover plate may be referred to as a second accommodating cavity. A height of an electronic component accommodated in the first accommodating cavity is higher than a height of an electronic component accommodated in the second accommodating cavity. For example, the height of the electronic component in the first accommodating cavity is less than or equal to 9 cm, and the height of the electronic component in the second accommodating cavity is less than or equal to 5 mm. To be specific, the first accommodating cavity can accommodate an electronic element with a high height, a large volume, and a high heat dissipation requirement, such as a power inverter assembly, a bus capacitor, or an inductor; and the second accommodating cavity can accommodate an electronic element with a low height, a small volume, and a low heat dissipation requirement, such as a surface mount capacitor, a surface mount resistor, or an indicator light.

In an example, the power inverter assembly 223 in the first accommodating cavity is configured to convert a direct current into an alternating current. In an example, the bus capacitor 222 in the first accommodating cavity is configured to store and smooth a direct current voltage. In an example, a function of the inductor in the first accommodating cavity includes at least one of filtering, direct current conversion, and power conversion. In an example, the inductor in the first accommodating cavity includes at least one of a filter inductor, an inductor in a direct current conversion assembly, and an inductor in the power inverter assembly. In an example, the surface mount resistor in the second accommodating cavity may be configured to: limit a current in a circuit, and resist interference and noise of the circuit. The surface mount capacitor in the second accommodating cavity may be configured to store a charge.

In some embodiments, the photovoltaic inverter 200 further includes an antenna 280. The antenna 280 is connected to the circuit board 220. To be specific, the power distribution device further includes the antenna 280, and the antenna 280 is installed on the first side plate of the housing 210 and is located between the signal connector 250 and the alternating current connector 260.

The antenna 280 is an external antenna configured with a WLAN, and is used for access maintenance of a proximal application (application, APP), and may be configured to increase signal strength and expand coverage.

In some embodiments, the photovoltaic inverter 200 further includes a smart signal stick 270, and the smart communication stick 270 is connected to the circuit board 220. To be specific, the power distribution device further includes the smart signal stick 270. The smart communication stick 270 is installed on the first side plate and is located on a lower side of the signal connector 250, that is, located between the signal connector 250 and the bottom plate of the shell 210. The smart communication stick 270 is configured to implement communication with an intelligent management system (cloud), that is, may upload data to the intelligent management system and receive information delivered by the intelligent management system.

In an example, the smart signal stick 270 is connected to the circuit board 220 through a cable. It may be understood that one end of the cable is connected to the circuit board 220, and the other end of the cable is provided with a universal serial bus (universal serial bus, USB) interface. The USB interface is provided on the shell 210. The smart communication stick 270 may be inserted into the USB interface.

In some embodiments, as shown in FIG. 2 and FIG. 3, the photovoltaic inverter 200 further includes an energy storage connector 290. In other words, the power distribution device further includes the energy storage connector 290, and the energy storage connector 290 may also be connected to the circuit board 220. The energy storage connector 290 is installed on the first side plate of the shell 210, and is located between the photovoltaic connector 240 and the signal connector 250. The energy storage connector 290 is configured to receive a direct current and output the direct current to the inverter circuit. The energy storage connector 290 is further configured to connect to an energy storage device.

It should be understood that when being connected to an energy storage apparatus (for example, a battery pack), a connector may be referred to as an energy storage connector; and when being connected to a photovoltaic module, a connector may be referred to as a photovoltaic connector. The energy storage connector and the photovoltaic connector may have similar appearances and structures. A main difference between the energy storage connector and the photovoltaic connector is different connected external devices. It may be understood that one end of the energy storage connector 290 may be connected to the circuit board 220, and the other end of the energy storage connector 290 may be connected to the energy storage system 300 (that is, an external energy storage apparatus).

It should be noted that the photovoltaic connector 240 is connected to the photovoltaic module 100, and the photovoltaic module 100 mainly converts solar energy into electric energy and then transmits the electric energy to the photovoltaic inverter 200 by using the photovoltaic connector 240. However, electric energy may not be provided at night or under a poor weather condition. In this case, the photovoltaic inverter 200 may be connected to an external energy storage apparatus (for example, a battery pack) through the energy storage connector 290, so that electric energy can also be provided at night or under a poor weather condition.

The energy storage connector 290 may obtain a direct current from an external energy storage apparatus, and output the direct current to the inverter circuit on the circuit board 220; and the inverter circuit may invert the direct current to an alternating current for use. In addition, the energy storage connector 290 may further transmit electric energy to the external energy storage apparatus, that is, output a direct current to the external energy storage apparatus. It should be understood that when the external energy storage apparatus (for example, a battery pack) is charged, a source of electric energy may be the electric energy provided by the photovoltaic module 100, or may be mains electricity. An alternating current may be rectified to a direct current through the rectifier circuit on the circuit board 220. The direct current may be transmitted to the external energy storage apparatus (for example, a battery pack) by using the energy storage connector 290, to charge the external energy storage apparatus (for example, a battery pack).

With reference to FIG. 2 to FIG. 5, the foregoing describes in detail a specific layout of the power distribution device of the photovoltaic inverter 200 provided in embodiments of this application. With reference to FIG. 6, the following describes a circuit structure of the photovoltaic inverter 200 provided in an embodiment of this application.

FIG. 6 is a diagram of a circuit structure of a photovoltaic inverter according to an embodiment of this application.

As shown in FIG. 6, in the photovoltaic inverter 200, the PV connector 240 may include a plurality of PV+ terminals (that is, positive terminals 2411) and a plurality of PV- terminals (that is, negative terminals 2421). The PV+ terminals are connected to a positive end of the photovoltaic module 100, and the PV- terminals are connected to a negative end of the photovoltaic module 100. In the PV module 100, a current flows from the negative end of the PV module 100 to the positive end of the PV module 100. The positive end and the negative end of the PV module 100 are connected to the circuit board 220 in the photovoltaic inverter 200 through the PV connector 140.

The rotary switch 230 is configured to control connection or disconnection between the photovoltaic module 100 and the circuit board 220, to implement functions of current conduction and isolation. The circuit board 220 may include a transformer circuit (that is, a DC-DC circuit) and an inverter circuit (a DC-AC circuit). The DC-DC circuit is configured to convert a direct current of one voltage value into a direct current of another voltage value. The DC-AC circuit is configured to convert a direct current into an alternating current, that is, to perform DC-AC conversion.

It should be understood that after a direct current input by the photovoltaic module 100 is transmitted to the circuit board 220, voltage conversion processing may be performed on the direct current through the DC-DC circuit; then, the processed direct current is converted into an alternating current through the DC-AC circuit; and the converted alternating current may be transmitted to the load 500 or the power grid 400 through the AC connector 260.

In some embodiments, the circuit board 220 may further include a control circuit. The control circuit is configured to: receive a signal transmitted by the signal connector 250, and transfer the received signal to each component (for example, an alternating current relay), to implement interaction. It should be understood that the signal connector 250 may perform signal interaction with the control circuit on the circuit board 220. For example, after communicating with an external device (for example, an energy storage apparatus, an electricity meter, or another photovoltaic inverter), the signal connector 250 feeds back information to the control circuit.

In some embodiments, the PV connector 240 includes the plurality of PV+ terminals and the plurality of PV- terminals. The plurality of PV+ terminals are separately connected to the circuit board 220 through a cable, and the plurality of PV- terminals may also be separately connected to the circuit board 220 through a cable.

In some other embodiments, the PV connector 240 includes the plurality of PV+ terminals and the plurality of PV- terminals. At least two of the plurality of PV+ terminals are combined into one path and then connected to the circuit board 220 through a cable. Alternatively, at least two of the plurality of PV- terminals are combined into one path and then connected to the circuit board 220 through a cable.

For example, as shown in FIG. 6, the PV connector 240 includes three PV+ terminals and three PV-terminals. The three PV+ terminals may be separately connected to the circuit board 220 through a cable. The three PV- terminals are combined into one path and then connected to the circuit board 220 through a cable.

In some embodiments, as shown in FIG. 6, the photovoltaic inverter 200 may be a single-phase inverter. The photovoltaic inverter 200 inverts a direct current into an alternating current for output. Single-phase inversion is to convert a voltage of the output alternating current into a single-phase voltage, for example, AC 220 V or 230 V. There are three jacks at an interface of the single-phase inverter. The three jacks are respectively marked as "N", "L", and "PE". Herein, L represents a live wire (live wire, marked as the letter L) that is usually a red or brown wire; N represents a neutral wire (neutral wire, marked as the letter N) that is usually a blue or white wire; and PE represents an earth wire (earth, marked as the letter E) that is usually a yellow and green wire.

In some other embodiments, the photovoltaic inverter 200 may be a three-phase inverter. Three-phase inversion is to convert a voltage of an output alternating current into a three-phase voltage, for example, AC 380 V or 400 V. Three-phase electricity includes three alternating current potentials that have same frequencies and equal amplitudes, but have a phase difference of 120° between each in sequence. An interface of the three-phase inverter has five jacks that are sequentially A, B, C, N, and PE. A phase A is yellow, a phase B is green, and a phase C is red. N represents a neutral wire that is a blue or white wire. PE represents an earth wire that is a yellow and green wire.

It should be noted that, in some embodiments, the photovoltaic inverter 200 includes the energy storage connector 290. The inverter circuit on the circuit board 220 may be replaced with a power control system (power control system, PCS) circuit. In other words, the PCS circuit may convert an input direct current into an alternating current, and may also convert an input alternating current into a direct current.

In some embodiments, the energy storage connector 290 may output a direct current to an external energy storage apparatus, and the output direct current is used for charging the external energy storage apparatus. The direct current may be from solar energy obtained by the photovoltaic module 100 on a PV side, or may be from mains electricity on an AC side. In some embodiments, the energy storage connector 290 may also input a direct current to the PCS circuit. The PCS circuit may convert the input direct current into an alternating current and output the alternating current to the load 500 of a user or the power grid 400.

In addition, an embodiment of this application further provides a power conversion apparatus. A structure of the power conversion apparatus is the same as that of the photovoltaic inverter 200. The photovoltaic connector 240 in the photovoltaic inverter 200 may also be referred to as a direct current connector. For the specific structure of the power conversion apparatus, refer to related descriptions of the photovoltaic inverter 200. Details are not described herein again.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A photovoltaic inverter, comprising:
a housing, comprising a shell (210) and a cover plate, wherein the shell (210) and the cover plate enclose an accommodating chamber, and the shell (210) comprises a first side plate and a second side plate that are adjacent;
a circuit board (220), disposed in the accommodating chamber, wherein the circuit board (220) further comprises a power module, and the power module is fastened to the circuit board (220) through pins;
a photovoltaic connector (240), disposed on the first side plate, wherein one end of the photovoltaic connector (240) is configured to connect to a photovoltaic module;
an alternating current connector (260), disposed on the first side plate and configured to connect to a load or a power grid;
a signal connector (250), disposed on the first side plate, located between the photovoltaic connector (240) and the alternating current connector (260), and configured to communicate data with an external device;
a rotary switch (230), disposed on the second side plate, wherein a part of the rotary switch (230) is located inside the accommodating chamber, a part of the rotary switch (230) is located outside the accommodating chamber, and the rotary switch (230) is electrically connected between the power module and the other end of the photovoltaic connector (240); and
a controller, configured to: when detecting that a fault comprising short circuit, overcurrent, or overvoltage occurs in the photovoltaic inverter or the photovoltaic module, control the rotary switch (230) to disconnect the photovoltaic module from the power module.

2. The photovoltaic inverter according to claim 1, wherein the shell (210) comprises a bottom plate that is disposed opposite to the cover plate, the circuit board (220) is located between the cover plate and the bottom plate, a heat sink is installed on a side that is of the bottom plate and that is away from the circuit board (220), the circuit board (220), the side plates of the shell (210), and the bottom plate of the shell (210) form an accommodating cavity, and the accommodating cavity is configured to accommodate a power inverter assembly, a bus capacitor, and an inductor.

3. The photovoltaic inverter according to claim 2, wherein the part that is of the rotary switch (230) and that is located inside the accommodating chamber is fastened to the circuit board (220) through pins, the rotary switch (230) is located in the accommodating cavity, and the rotary switch (230) is connected to the power module through a metal routing (221) on the circuit board (220).

4. The photovoltaic inverter according to claim 1, wherein the photovoltaic inverter further comprises an energy storage connector (290), the energy storage connector (290) is connected to the circuit board (220), the energy storage connector (290) is installed on the first side plate and is located between the photovoltaic connector (240) and the signal connector (250), and the energy storage connector (290) is further configured to connect to an energy storage device.

5. The photovoltaic inverter according to claim 1, wherein the first side plate and the second side plate are connected on a first side edge, and the rotary switch (230) and the photovoltaic connector (240) are both installed close to the first side edge.

6. The photovoltaic inverter according to claim 1, wherein the rotary switch (230) is connected to the circuit board (220) through pins, the photovoltaic connector (240) is connected to the circuit board (220) through a rigid conductor, and the photovoltaic connector (240) is electrically connected to the rotary switch (230) through a metal routing on the circuit board (220).

7. The photovoltaic inverter according to claim 1, wherein the photovoltaic connector (240) comprises a plurality of positive connectors (241) and a plurality of negative connectors (242), the plurality of positive connectors (241) comprise a plurality of positive terminals (2411), the plurality of negative connectors (242) comprise a plurality of negative terminals (2421), and the rotary switch (230) is a multi-pole rotary switch; and
each of the positive terminals (2411) is connected to one pole of the rotary switch (230) through a metal routing (221) on the circuit board (220), and after negative current combination of the plurality of negative terminals (2421), a connection to one pole of the rotary switch (230) is implemented through a metal routing (221) on the circuit board (220).

8. The photovoltaic inverter according to claim 2, wherein the photovoltaic inverter further comprises a smart communication stick (270), the smart communication stick (270) is connected to the circuit board (220), and the smart communication stick (270) is installed on the first side plate and is located between the signal connector (250) and the bottom plate of the shell (210).

9. The photovoltaic inverter according to any one of claims 1 to 8, wherein the photovoltaic inverter further comprises an antenna (280), the antenna (280) is connected to the circuit board (220), and the antenna (280) is installed on the first side plate and is located between the signal connector (250) and the alternating current connector (260).

10. A power conversion apparatus, comprising:
a housing, comprising a shell and a cover plate, wherein the shell and the cover plate enclose an accommodating chamber, and the shell comprises a first side plate and a second side plate that are adjacent;
a circuit board, disposed in the accommodating chamber, wherein the circuit board further comprises a power module, and the power module is fastened to the circuit board through pins;
a direct current connector, disposed on the first side plate, wherein one end of the direct current connector is configured to connect to a photovoltaic module;
an alternating current connector, disposed on the first side plate and configured to connect to a load or a power grid;
a signal connector, disposed on the first side plate, located between the direct current connector and the alternating current connector, and configured to communicate data with an external device;
a rotary switch, disposed on the second side plate, wherein a part of the rotary switch is located inside the accommodating chamber, a part of the rotary switch is located outside the accommodating chamber, and the rotary switch is electrically connected between the power module and the other end of the direct current connector; and
a controller, configured to: when detecting that a fault comprising short circuit, overcurrent, or overvoltage occurs in the photovoltaic inverter or the photovoltaic module, control the rotary switch to disconnect the photovoltaic module from the power module.

11. The power conversion apparatus according to claim 10, wherein the shell comprises a bottom plate that is disposed opposite to the cover plate, the circuit board is located between the cover plate and the bottom plate, a heat sink is connected to a side that is of the bottom plate and that is away from the circuit board, the circuit board, the side plates of the shell, and the bottom plate of the shell form an accommodating cavity, and the accommodating cavity is configured to accommodate a power inverter assembly, a bus capacitor, and an inductor.

12. The power conversion apparatus according to claim 11, wherein the part that is of the rotary switch and that is located inside the accommodating chamber is fastened to the circuit board through pins, the rotary switch is located in the accommodating cavity, and the rotary switch is connected to the power module through a metal routing on the circuit board.

13. The power conversion apparatus according to claim 10, wherein the power conversion apparatus further comprises an energy storage connector, the energy storage connector is connected to the circuit board, the energy storage connector is installed on the first side plate and is located between the direct current connector and the signal connector, and the energy storage connector is further configured to connect to an energy storage device.

14. The power conversion apparatus according to claim 10, wherein the first side plate and the second side plate are connected on a first side edge, and the rotary switch and the direct current connector are both installed close to the first side edge.

15. The power conversion apparatus according to claim 10, wherein the rotary switch is connected to the circuit board through pins, the direct current connector is connected to the circuit board through a rigid conductor, and the direct current connector is electrically connected to the rotary switch through a metal routing on the circuit board.

16. The power conversion apparatus according to claim 10, wherein the direct current connector comprises a plurality of positive connectors and a plurality of negative connectors, the plurality of positive connectors comprise a plurality of positive terminals, the plurality of negative connectors comprise a plurality of negative terminals, and the rotary switch is a multi-pole rotary switch; and
each of the positive terminals is connected to one pole of the rotary switch through a metal routing on the circuit board, and after negative current combination of the plurality of negative terminals, a connection to one pole of the rotary switch is implemented through a metal routing on the circuit board.

17. The power conversion apparatus according to claim 11, wherein the power conversion apparatus further comprises a smart communication stick, the smart communication stick is connected to the circuit board, and the smart communication stick is installed on the first side plate and is located between the signal connector and the bottom plate of the shell.

18. The power conversion apparatus according to any one of claims 10 to 17, wherein the power conversion apparatus further comprises an antenna, the antenna is connected to the circuit board, and the antenna is installed on the first side plate and is located between the signal connector and the alternating current connector.
